# EUROPÄISCHE PATENTSCHRIFT

(11) **EP 3 771 911 B1**
(45) Veröffentlichungstag und Bekanntmachung des Hinweises auf die Patenterteilung: **06.09.2023**
(21) Anmeldenummer: 19189488.0
(22) Anmeldetag: 31.07.2019
(51) Int. Cl.: G01R 31/12, G01R 31/16

(54) **PRÜFVORRICHTUNG FÜR ELEKTRISCHE LEITUNGEN**
CONNECTING DEVICE FOR ELECTRICAL LINES
DISPOSITIF DE CONTRÔLE POUR CONDUITES ÉLECTRIQUES

(43) Veröffentlichungstag der Anmeldung: 03.02.2021
(73) Patentinhaber: Adaptronic Prüftechnik GmbH, 97877 Wertheim (DE)
(72) Erfinder: HIESER, Hans-Peter, 97877 Wertheim (DE); HABERKORN, Michael, 97877 Wertheim (DE)
(74) Vertreter: PPR AG

(56) Entgegenhaltungen:
- DE-A1- 10 024 809
- DE-B4- 10 024 809
- FR-A1- 2 716 720
- FR-A1- 2 716 721
- US-A- 4 859 953

## Beschreibung

Die Erfindung betrifft eine Prüfvorrichtung zur Prüfung der Isolierung einer elektrischen Leitung, insbesondere eines Kabels oder eines Kabelbaumes, vorzugsweise zur Detektion von Fehlstellen in der Isolierung der elektrischen Leitung, nach dem Oberbegriff des Anspruchs 1.

Kabel sind für viele Anwendungen vor deren Einsatz einer Prüfung zu unterziehen. Dabei stellt die Durchschlagfestigkeit der Kabelisolierung ein wichtiges Kriterium dar. Durch solche Testverfahren soll ausgeschlossen werden, dass in der Isolierung Fehlstellen, welche während des Betriebes elektrischer Kreise in Maschinen, Fahrzeugen, Flugzeugen, etc. ein Gefahrenpotential darstellen, vorhanden sind.

Die US 4,859,953 offenbart eine Testanordnung zum Testen eines vorgefertigten Kabelbaumes. Der Teststand umfasst eine Vielzahl von modularen Rahmeneinheiten mit offenen Enden, um miteinander verbunden zu werden. Dadurch kann die Länge des Teststandes verändert werden, wodurch verschiedene Typen von Kabelbäumen getestet werden können. Diese Testanordnung eignet sich jedoch nicht dazu, die Isolierung der Kabelbäume bzw. die Durchschlagsfestigkeit der Kabelisolierung zu prüfen. Der Test erfolgt auch nicht unter Vakuumbedingungen; überhaupt ist die Herstellung eines Vakuums mit der in der US 4,859,953 offenbarten Testanordnung nicht möglich.

Die FR2716721 offenbart eine Vorrichtung zum Prüfen von elektrischen Kabeln. Die Vorrichtung umfasst ein Gehäuse zur Aufnahme eines ionisierenden Gases. Das zu prüfende Kabel ist dabei durch - mit Dichtungsringen versehene - Löcher im Gehäuse geführt, sodass immer nur ein Abschnitt des Kabels von dem Gehäuse umgeben ist.

Die DE10024809B4 offenbart beispielsweise eine Einrichtung zur Detektion von Schäden in der Isolierung von elektrischen Leitungen und Kabelbäumen mittels eines Prüfraumes. Der zu detektierende Bereich der Leitung oder des Kabelbaumes wird von einem den Prüfraum bildenden Prüfgefäss zangenartig umfasst. Der Prüfraum wird vor der Detektion abgeschlossen und dessen Atmosphäre mittels Gasaustausch durch ein Prüfgas oder Prüfgasgemisch mit einer geringeren Durchschlagsspannung als der von Luft ersetzt.

Nachteilig an dieser bekannten Lösung ist, dass das zangenartige Prüfgefäss nur einen Teil des Kabels umschliessen kann. Ausserdem ist der Prüfraum auch in geschlossener Stellung nicht vollständig dicht, sodass jedenfalls ein Prüfgas(gemisch) verwendet werden muss, um das Eindringen von Luft in den Prüfraum zu verhindern. Es hat sich jedoch herausgestellt, dass die Detektion von Fehlstellen in einer Prüfgas-Atmosphäre nicht zuverlässig ist. Zudem ist der Aufwand durch die gesonderte Bereitstellung eines Prüfgases sehr aufwendig.

Aufgabe der vorliegenden Erfindung ist es somit, eine Vorrichtung zu schaffen, welche die vorgenannten Nachteile nicht aufweist und insbesondere eine schnellere und zuverlässigere Prozedur für die Prüfung von elektrischen Leitungen ermöglicht. Der Aufwand soll möglichst gering und die Bedienerfreundlichkeit hoch sein. Ausserdem soll die optionale Möglichkeit geschaffen werden, auch ohne die Verwendung von Prüfgas zuverlässige Prüfungen vornehmen zu können.

Die Aufgabe wird durch die Merkmale des unabhängigen Anspruchs gelöst. Vorteilhafte Weiterbildungen sind in den Figuren und in den abhängigen Patentansprüchen dargelegt.

Gemäss der Erfindung weist die Prüfvorrichtung eine dicht verschliessbare, evakuierbare Kammer zur vollständigen Aufnahme der zu prüfenden elektrischen Leitung auf, wobei im Inneren der Kammer zumindest eine elektrische Anschlussstelle, vorzugsweise in Form eines Steckvorrichtungsteils, zum Anschliessen der zu prüfenden elektrischen Leitung angeordnet ist und von der Anschlussstelle eine elektrische Durchführung aus der Kammer herausführt.

Die Kammer ist dicht verschliessbar und evakuierbar, sodass ein Vakuum, zumindest aber ein Unterdruck, im Inneren der Kammer erzeugt werden kann. Die elektrischen Durchführungen von der/den Anschlussstellen nach aussen sind dabei derart ausgebildet, dass sie die Dichtigkeit der Kammer gewährleisten. Die vorzugsweise als Steckvorrichtungsteil ausgebildeten Anschlussstellen können dabei einen Flansch in der Wand-Durchführung von aussen nach innen bilden.

Durch Anlegen einer Prüfspannung (bzw. eines - zeitlich variablen - Prüfspannungsverlaufes) zwischen der elektrischen Leitung und einer Elektrode, welche beispielsweise durch das Gehäuse der Kammer 3 bzw. eines Teils des Gehäuses der Kammer 3s gebildet sein kann, wird die Durchschlagsfestigkeit der Kabelisolierung geprüft.

Der Vorteil der Erfindung ist insbesondere darin zu sehen, dass sich die zu prüfende elektrische Leitung während der Prüfprozedur zur Gänze, d. h. einschliesslich Ihrer Enden, welche mit Steckern bestückt sein können, im Inneren der Kammer befindet. Das Testverfahren kann somit immer unter denselben Bedingungen und unabhängig von der Form und Grösse der zu prüfenden Leitungen durchgeführt werden. Die Prüfung kann unter Vakuum erfolgen, d. h. es wird nicht zwingendermassen ein Prüfgas benötigt. All dies macht das Verfahren einfach, reproduzierbar und zuverlässig. Das vollständig in der Prüfkammer aufgenommene Kabel kann mit in einer Wand des Gehäuses der Kammer 3 vorgesehenen Steckern verbunden sein.

Ein weiterer Vorteil besteht darin, dass die Prüfung zur Gänze zerstörungsfrei erfolgt.

Es ist bevorzugt, wenn die Prüfung der elektrischen Leitung unter Vakuum durchgeführt wird (d. h. bei evakuierter Kammer). Durch die Prüfung unter Vakuum wird ebenso wie in Schutzgas die Durchschlagspannung herabgesetzt. Dies führt dazu, dass Durchschläge bei deutlich niedrigerer Spannung als bei Normaldruck erfolgen.

Die für die Prüfung benötigte (Hoch-)Spannungsquelle kann dabei ausserhalb der Kammer angeordnet sein. Die elektrischen Durchführungen sorgen für die elektrische Verbindung von aussen ins Innere der Kammer.

Bei der Erfindung handelt es sich insbesondere um eine Kabelprüfvorrichtung zur Prüfung und/oder Feststellung der

Durchschlagfestigkeit der Kabelisolierung. Unter dem Begriff Kabel werden in vorliegender Anmeldung sowohl einfache Kabel (d. h. ohne Verzweigungen), gegebenenfalls mit mehreren parallellaufenden Leitungen, als auch mehr oder weniger komplexe Kabelstrukturen bzw. Kabelbäume verstanden. Für all diese ist die vorliegende Prüfvorrichtung geeignet.

Eine bevorzugte Ausführungsform zeichnet sich dadurch aus, dass zumindest ein Teil, vorzugsweise zumindest die Hälfte oder zumindest der Boden, des Gehäuses der Kammer aus leitfähigem Material, insbesondere Metall, gebildet ist, welches mit einer Spannungsquelle und/oder einem Potential, vorzugsweise Erde, verbunden ist. Das Gehäuse der Kammer wird hier gleichzeitig als Elektrode verwendet, um eine Spannung aufzubauen und im Fall einer vorhandenen Fehlstelle in der Isolierung den Durchschlag messbar zu machen. Dies erfolgt vorzugsweise durch Messung des Stromes. Ebenso wäre eine Messung des elektrischen Feldes denkbar. Gemäss einer weiteren Ausführungsform könnte der im Fall eines Durchschlages auftretende Lichtbogen von der Fehlstelle in der Isolierung zum Gehäuse der Kammer mittels einer optischen Erfassungseinrichtung, wie z. B. einer Kamera, detektiert bzw. sichtbar gemacht werden. In einer alternativen Ausführungsform könnte eine Elektrode innerhalb der Kammer angeordnet werden, z. B. in Form einer flächigen oder plattenförmigen Elektrode, welche vorzugsweise als Auflagefläche für die zu prüfende Leitung dient.

Eine bevorzugte Ausführungsform zeichnet sich dadurch aus, dass die Prüfvorrichtung eine Messeinrichtung zum Überwachen der elektrischen Leitung umfasst. Die Messeinrichtung kann dazu dienen, die ordnungsgemässe Spannungsbeaufschlagung zu überwachen bzw. zu kontrollieren. Ziel ist hier eine Kontrolle, ob die Prüfspannung auch in der zu prüfenden Leitung ankommt. Alternativ oder zusätzlich kann die Messeinrichtung auch dazu dienen, einen Spannungsabfall aufgrund eines Durchschlages an einer Fehlstelle zu detektieren.

Es ist bevorzugt, wenn diese Messeinrichtung ausserhalb der Kammer angeordnet ist und mit einer elektrischen Anschlussstelle im Inneren der Kammer verbunden ist. Die Messeinrichtung kann z. B. ein Amperemeter, ein Voltmeter, ein elektrisches Feldmeter und/oder eine optische Erfassungseinrichtung (wie z. B. eine Kamera), welche zur optischen Erfassung eines aus der Isolierung austretenden Lichtbogens eingerichtet ist, umfassen.

Eine bevorzugte Ausführungsform zeichnet sich dadurch aus, dass im Inneren der Kammer zumindest zwei elektrische Anschlussstellen, vorzugsweise jeweils in Form eines Steckvorrichtungsteils, angeordnet sind, wobei eine der Anschlussstellen mit einer (ausserhalb der Kammer angeordneten) Spannungsquelle und eine andere Anschlussstelle mit der (ausserhalb der Kammer angeordneten) Messeinrichtung verbunden ist. Eine zu prüfende elektrische Leitung wird mit einem ihrer Enden über die eine Anschlussstelle an die Spannungsquelle und mit einem anderen Ende über die andere Anschlussstelle an die Messeinrichtung angeschlossen.

Es kann daher zwei Arten von elektrischen Anschlussstellen geben:
- eine für das Einspeisen der Prüfspannung, optional mit Aufschalte-Einrichtung, die die Aufschaltung selektiv auf die Anschlussstellen ermöglicht.
- eine andere für das Messen der Spannung (Kontrolle, ob die Prüfspannung auch in der zu prüfenden Leitung ankommt).

Eine bevorzugte Ausführungsform zeichnet sich dadurch aus, dass im Inneren der Kammer zumindest zwei, vorzugsweise zumindest fünf elektrische Anschlussstellen, vorzugsweise jeweils in Form eines Steckvorrichtungsteils, angeordnet sind, wobei vorzugsweise von den Anschlussstellen jeweils eine elektrische Durchführung aus der Kammer herausführt oder wobei vorzugsweise die Anschlussstellen unterschiedliche Form aufweisen. Je grösser die Anzahl der Anschlussstellen, desto mehr Leitungen können in einem Zyklus geprüft werden. Ausserdem ermöglicht eine grössere Anzahl von Anschlussstellen die Prüfung von komplexen Kabelbäumen mit mehreren Steckern. Bei unterschiedlich dimensionierten Anschlussstellen können auch Kabeln mit unterschiedlichen Steckergeometrien auf einfache Weise überprüft werden.

In einer bevorzugten Ausführungsform sind die Anschlussstellen austauschbar, sodass die Prüfvorrichtung für unterschiedliche Steckergeometrien adaptierbar ist.

Eine bevorzugte Ausführungsform zeichnet sich dadurch aus, dass zumindest zwei, vorzugsweise zumindest fünf elektrische Anschlussstellen, vorzugsweise jeweils in Form eines Steckvorrichtungsteils, an einem gemeinsamen Trägerelement, vorzugsweise in Form einer Leiste oder Platte, welches vom Gehäuse der Kammer abnehmbar ist, verankert sind. Die Anschlussstellen (Steckvorrichtungsteil) sind vorzugsweise vom gemeinsamen Trägerelement einzeln abnehmbar. Dies ermöglicht ein einfaches Abmontieren und einen einfachen nachfolgenden Austausch der Anschlussstellen.

Eine bevorzugte Ausführungsform zeichnet sich dadurch aus, dass die zumindest eine elektrische Anschlussstelle in oder an einer Innenwand der Kammer verankert ist.

Eine bevorzugte Ausführungsform zeichnet sich dadurch aus, dass die zumindest eine elektrische Anschlussstelle über die elektrische Durchführung mit einer ausserhalb der Kammer angeordneten Spannungsquelle verbunden ist.

Eine bevorzugte Ausführungsform zeichnet sich dadurch aus, dass die Prüfvorrichtung eine mit der Kammer verbundene Vakuumpumpe zum Evakuieren der Kammer aufweist.

Eine bevorzugte Ausführungsform zeichnet sich dadurch aus, dass die Kammer durch einen wannenartigen Teil und eine den wannenartigen Teil abdeckende Abdeckung gebildet wird, wobei vorzugsweise zwischen wannenartigem Teil und Abdeckung eine Dichtung vorgesehen ist, die im geschlossenen Zustand der Kammer zwischen Abdeckung und wannenartigem Teil liegt. Diese Ausführungsform gewährleistet eine hohe Bedienerfreundlichkeit, da die zu prüfende Leitung lediglich in die Wanne gelegt und mit den Anschlussstellen verbunden werden muss.

Eine bevorzugte Ausführungsform zeichnet sich dadurch aus, dass die zumindest eine elektrische Anschlussstelle in einer Seitenwand des wannenartigen Teils angeordnet ist, wobei die Seitenwand mit dem Boden des wannenartigen Teils im Inneren der Kammer einen stumpfen Winkel einschliesst, wobei vorzugsweise der stumpfe Winkel zwischen 100° und 150°, vorzugsweise im Wesentlichen 120°, beträgt. Durch diese Massnahme sind die Anschlussstellen genau zur Bedienperson hin gerichtet, sodass das Anschliessen der Leitung besonders einfach erfolgen kann.

Eine bevorzugte Ausführungsform zeichnet sich dadurch aus, dass die Prüfvorrichtung ein die Kammer tragendes, vorzugsweise verfahrbares Gestell aufweist, wobei vorzugsweise die Kammer und das Gestell einen Tisch bilden. Neben der Bedienerfreundlichkeit werden hier auch die Flexibilität und das Einsatzgebiet der Prüfvorrichtung erhöht.

Eine bevorzugte Ausführungsform zeichnet sich dadurch aus, dass zumindest der wannenartige Teil der Kammer einen vom Gestell abnehmbaren Einsatz bildet. Auf diese Weise kann die Kammer als Ganzes ausgetauscht werden.

Eine bevorzugte Ausführungsform zeichnet sich dadurch aus, dass die Prüfvorrichtung eine Steuereinrichtung umfasst, welche mit einer Benutzerschnittstelle dazu eingerichtet ist,
- die Parametrisierung der Prüfung durch eine Bedienperson, insbesondere eine Parametereingabe, z. B. der Höhe der Prüfspannung, der Prüfdauer, des Drucks in der Kammer, der zulässige Grenzstrom (Leckstrom) etc., zu ermöglichen,
- den Prüfablauf zu steuern, und/oder
- die Prüfergebnisse (tatsächliche Prüfbedingungen, erreichter Strom, Spannungsabfall aufgrund eines Durchschlages, Zeitpunkt des Durchschlages, Lokalisierung der Fehlstelle, etc.) zu dokumentieren.

Eine bevorzugte Ausführungsform zeichnet sich dadurch aus, dass das Gestell zumindest eine mit der zumindest einen elektrischen Anschlussstelle verbundene Spannungsquelle und/oder eine mit der Kammer verbundene Vakuumpumpe und/oder eine Steuereinrichtung zur Steuerung der Prüfvorrichtung und/oder eine Benutzerschnittstelle zur Bedienung der Prüfvorrichtung trägt. Dadurch wird eine kompakte Lösung angeboten, welche sämtliche erforderliche Komponenten integral beinhaltet.

Eine bevorzugte Ausführungsform zeichnet sich dadurch aus, dass die Prüfvorrichtung zumindest eine Sensorvorrichtung zur Detektion und/oder Lokalisierung eines Durchschlages durch die Isolierung der zu prüfenden elektrischen Leitung aufweist, wobei vorzugsweise die Sensorvorrichtung eine mit einer elektrischen Anschlussstelle verbundene Messeinrichtung, insbesondere ein Amperemeter oder ein Voltmeter, umfasst. Die Sensorvorrichtung könnte z. B. auch eine bilderfassende Vorrichtung, insbesondere eine Kamera, umfassen.

Eine bevorzugte Ausführungsform zeichnet sich dadurch aus, dass die Kammer, vorzugsweise in ihrer Abdeckung, zumindest ein Sichtfenster (z. B. in Form eines Bullauges) oder zumindest einen durchsichtigen Abschnitt aufweist. Die Bedienperson kann dabei einen Durchschlag, welcher in Form eines Lichtbogens auftritt, sofort erkennen. Das Sichtfenster kann optional für Demonstrationszwecke verwendet werden, ist jedoch nicht zwingend erforderlich. Insbesondere bei einer optischen Auswertung, z. B. mittels einer innerhalb der Kammer angeordneten Kamera, wäre es bevorzugt, keine Sichtfenster vorzusehen.

Eine bevorzugte Ausführungsform zeichnet sich dadurch aus, dass die Abdeckung durch eine vorzugsweise horizontal verschiebbare Platte, welche eine Tischplatte der Prüfvorrichtung bildet, gebildet wird. Dadurch wird einerseits eine platzsparende Konstruktion erreicht, andererseits eine für die Bedienperson ergonomisch optimale Höhe der Kammer und deren Abdeckung bewirkt.

Eine bevorzugte Ausführungsform zeichnet sich dadurch aus, dass die Abdeckung zwischen geschlossener und geöffneter Stellung, vorzugsweise in einer horizontalen Richtung, verschiebbar ist, wobei vorzugsweise die Abdeckung durch eine, bevorzugt rollengelagerte, Führung geführt ist.

Eine bevorzugte Ausführungsform zeichnet sich dadurch aus, dass in einem Bereich zwischen der elektrischen Anschlussstelle und einer Wand der Kammer eine Dichtung zur Abdichtung des Inneren der Kammer gegenüber dem Bereich ausserhalb der Kammer angeordnet ist. Dies gewährleistet einen vakuumdichten Übergang bei gleichzeitiger Möglichkeit des Austausches der Anschlussstelle.

Eine bevorzugte Ausführungsform zeichnet sich dadurch aus, dass die zumindest eine elektrische Anschlussstelle eine - vorzugsweise dem Inneren der Kammer zugewandte - Dichtung aufweist, um bei angeschlossenem elektrischen Leiter das Innere der Kammer gegen einen zwischen der elektrischen Anschlussstelle und einem Stecker der zu prüfenden elektrischen Leitung gebildeten Raum - luftdicht und/oder elektrisch - abzudichten. Dadurch kann die Dichtfunktion im Bereich der Anschlussstelle noch weiter erhöht werden. Diese Dichtung kann aber auch als elektrische Dichtung (d. h. als Isolierung) verstanden werden, die einen elektrischen Überschlag zu den elektrischen Steckern der Anschlussstellen verhindert.

Eine bevorzugte Ausführungsform zeichnet sich dadurch aus, dass die zumindest eine elektrische Anschlussstelle einen Fixiermechanismus, vorzugsweise einen Schnappmechanismus, zum Fixieren eines Steckvorrichtungsteils der zu prüfenden elektrischen Leitung an der Anschlussstelle aufweist.

Eine bevorzugte Ausführungsform zeichnet sich dadurch aus, dass auf dem Boden der Kammer ein Abstandhalter aus elektrisch isolierendem Material, vorzugsweise in Form eines Gitters oder Netzes oder in Form von Leisten, zur Beabstandung einer zu prüfenden elektrischen Leitung vom Boden der Kammer angeordnet ist.

Das Ziel wird auch erreicht mit einem Prüfverfahren zur Prüfung der Isolierung einer elektrischen Leitung, insbesondere eines Kabels oder eines Kabelbaumes, vorzugsweise zur Detektion von Fehlstellen in der Isolierung der elektrischen Leitung, mittels einer erfindungsgemässen Prüfvorrichtung, wobei das Verfahren die Schritte umfasst:
- Einbringen zumindest einer zu prüfenden elektrischen Leitung in die Kammer und Anschliessen der elektrischen Leitung an zumindest eine elektrische Anschlussstelle der Kammer,
- Evakuieren der Kammer, vorzugsweise bis ein Druck von weniger als 500mbar, vorzugsweise weniger als 200mbar, besonders bevorzugt zumindest weniger als 100mbar, in der Kammer erreicht ist,
- Anlegen einer elektrischen Spannung zwischen der zu prüfenden elektrischen Leitung und einer Elektrode, welche vorzugsweise zumindest eine Innenseite der Kammer bildet oder innerhalb der Kammer angeordnet ist, und/oder zwischen zu prüfenden elektrischen Leitungen.

Ein weiterer Schritt des Verfahrens umfasst die - direkte oder indirekte - Überwachung der zu prüfenden elektrischen Leitung mittels einer Sensorvorrichtung (bzw. Messeinrichtung). Dadurch kann die Durchschlagsfestigkeit der Isolierung geprüft und/oder kann ein allfälliger Durchschlag detektiert und/oder eine oder mehrere Fehlstellen in der Isolierung aufgefunden werden. Z. B. kann die Durchschlags-Erkennung durch Bewertung des Stroms auf Überschreiten eines einstellbaren Grenzwerts erfolgen.

Alternativ oder zusätzlich kann die elektrische Spannung auch zwischen zwei oder mehreren zu prüfenden elektrischen Leitungen angelegt werden. Die Messung erfolgt dann entsprechend zwischen den Leitungen.

Während die elektrische Spannung angelegt ist, wird mittels der Sensorvorrichtung, welche - direkt oder indirekt - mit der zu prüfenden elektrischen Leitung und/oder der Elektrode verbunden sein kann, überwacht, ob ein Durchschlag erfolgt bzw. inwieweit die elektrische Spannung abfällt. Die Sensoreinrichtung in Form einer elektrischen Messeinrichtung kann z. B. ein Amperemeter, ein Voltmeter und/oder ein elektrisches Feldmeter umfassen. Die Sensoreinrichtung könnte auch eine optische Erfassungseinrichtung (wie z. B. eine Kamera) zur Erfassung eines aus der Isolierung austretenden Lichtbogens sein.

Eine bevorzugte Ausführungsform zeichnet sich dadurch aus, dass der Schritt des Anlegens der elektrischen Spannung und der Schritt der Überwachung der zu prüfenden elektrischen Leitung bei evakuierter Kammer (d. h. wenn in der Kammer Unterdruck bzw. Vakuum herrscht) durchgeführt werden, vorzugsweise bei einem Druck in der Kammer von weniger als 500mbar, vorzugsweise weniger als 200mbar, besonders bevorzugt weniger als 100mbar.

Eine bevorzugte Ausführungsform zeichnet sich dadurch aus, dass die angelegte elektrische Spannung zwischen 1kV und 50kV, vorzugsweise zwischen 10kV und 30kV, beträgt.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung beschrieben sind.

Die Bezugszeichenliste ist wie auch der technische Inhalt der Patentansprüche und Figuren Bestandteil der Offenbarung. Die Figuren werden zusammenhängend und übergreifend beschrieben. Gleiche Bezugszeichen bedeuten gleiche Bauteile, Bezugszeichen mit unterschiedlichen Indices geben funktionsgleiche oder ähnliche Bauteile an.

### Es zeigen dabei:

- Fig. 1: eine Ausführungsform einer erfindungsgemässen Prüfvorrichtung,
- Fig. 2: die Aussenseite einer Seitenwand der Kammer,
- Fig. 3: eine elektrische Anschlussstelle mit angeschlossener elektrischen Leitung im Detail,
- Fig. 4: die evakuierbare Kammer im Detail,
- Fig. 5: die Rückseite der Prüfvorrichtung mit Spannungsquelle und Vakuumpumpe, und
- Fig. 6: eine Ausführungsform der Erfindung.

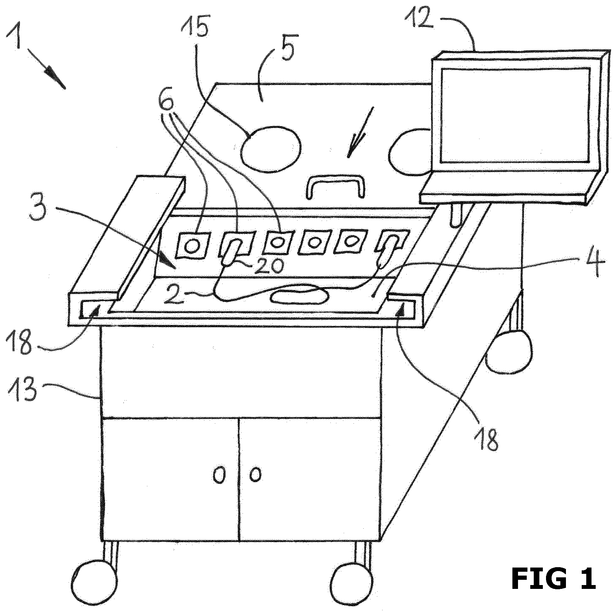

Fig. 1 zeigt eine Prüfvorrichtung 1 zur Prüfung der Isolierung einer elektrischen Leitung 2, insbesondere eines Kabels oder eines Kabelbaumes. Dabei werden insbesondere Fehlstellen in der Isolierung der elektrischen Leitung 2 detektiert.

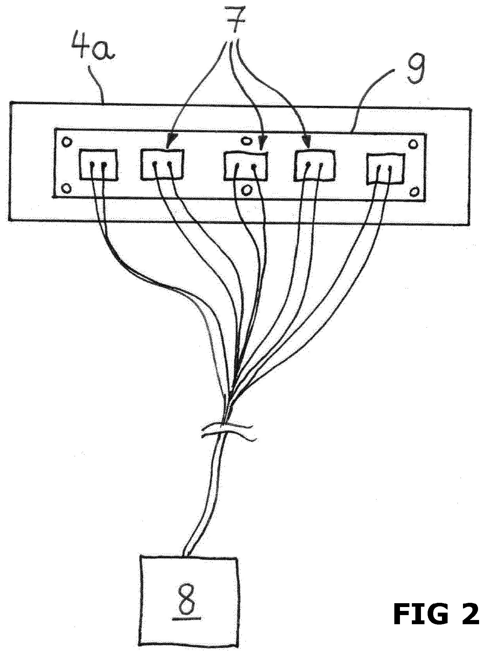

Die Prüfvorrichtung 1 weist eine dicht verschliessbare, evakuierbare Kammer 3 zur vollständigen Aufnahme der zu prüfenden elektrischen Leitung 2 auf. Im Inneren der Kammer 3 sind mehrere elektrische Anschlussstellen 6 - hier in Form von Steckvorrichtungsteilen, wie Anschlussstecker oder Anschlussbuchsen - zum Anschliessen der zu prüfenden elektrischen Leitung 2 angeordnet. Von den Anschlussstellen 6 führt jeweils eine elektrische Durchführung 7 aus der Kammer 3 heraus (Figs. 2, 3 und 4), um die Anschlussstelle 6 mit einer Spannungsquelle 8, welche Teil einer Messeinrichtung sein kann, zu verbinden.

Beim Anlegen einer Hochspannung (nach Evakuierung der Kammer) erfolgt im Bereich des Defekts ein Spannungsüberschlag zu einer Elektrode, welcher als aus dem Kabel austretender Lichtbogen ersichtlich wird. Die Elektrode wird auf konstantem Potential (z. B. Erde) gehalten. Es ist bevorzugt, wenn das Gehäuse oder ein Gehäuseteil der Kammer 3 diese Elektrode bildet.

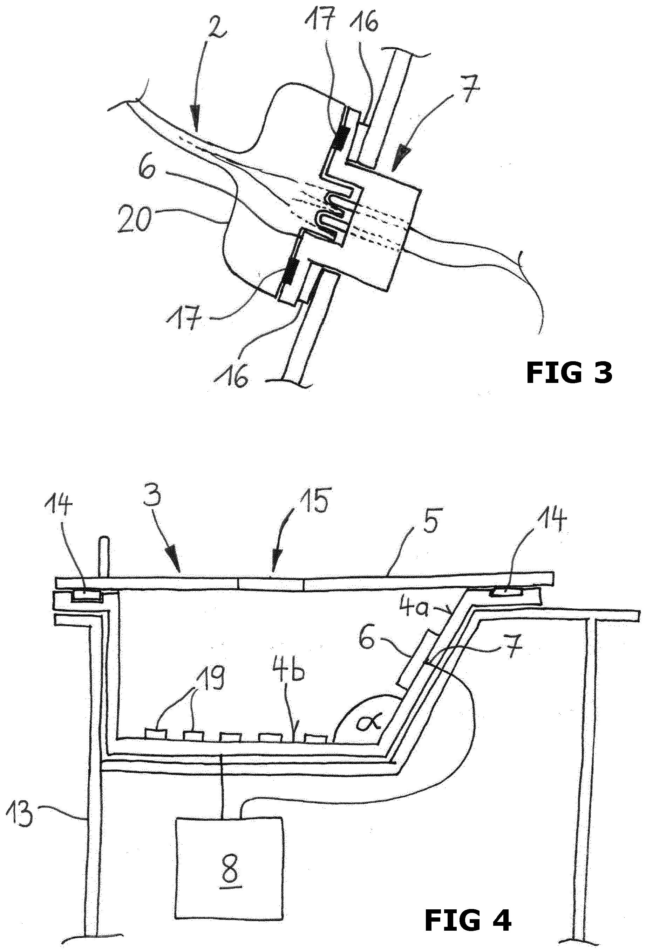

In der dargestellten Ausführungsform ist somit zumindest ein Teil, vorzugsweise zumindest die Hälfte oder zumindest der Boden, des Gehäuses der Kammer 3 aus leitfähigem Material, insbesondere Metall, gebildet, welches mit einer Spannungsquelle 8 und/oder einem Potential, vorzugsweise Erde, verbunden ist (Fig. 4).

Grundsätzlich wäre es möglich auch nur eine Anschlussstelle 6 vorzusehen, bevorzugt sind jedoch zwei oder mehr, um die zu prüfenden Leitungen an beiden Enden oder mehrere Leitungen gleichzeitig oder komplexe Kabelbäume mit mehreren Anschlüssen anschliessen zu können. Die einzelnen Anschlussstellen 6 können auch eine unterschiedliche Form aufweisen.

In der Ausführungsform der Fig. 2 sind die elektrischen Anschlussstellen 6 an einem gemeinsamen Trägerelement 9, vorzugsweise in Form einer Leiste oder Platte, welches vom Gehäuse der Kammer 3 abnehmbar ist, verankert.

Wie aus Fig. 1 und Fig. 4 zu sehen, ist/sind die elektrische(n) Anschlussstelle(n) 6 in oder an einer Innenwand der Kammer 3 verankert.

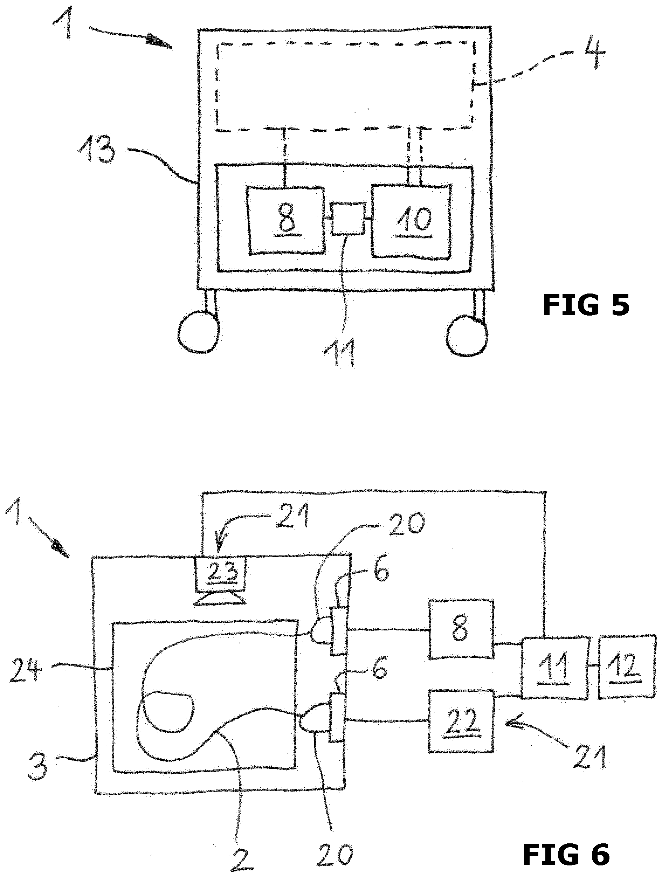

Aus Fig. 5 ist zu sehen, dass die elektrische Anschlussstelle 6 über die elektrische Durchführung 7 mit einer ausserhalb der Kammer 3 angeordneten Spannungsquelle 8 verbunden ist. An die Kammer 3 ist auch eine Vakuumpumpe 10 zum Evakuieren der Kammer 3 angeschlossen.

Die Kammer 3 in Fig. 1 und Fig. 4 ist durch einen wannenartigen Teil 4 und eine den wannenartigen Teil 4 abdeckende Abdeckung 5 gebildet. Zwischen dem wannenartigen Teil 4 und der Abdeckung 5 kann eine Dichtung 14 vorgesehen sein, die im geschlossenen Zustand der Kammer zwischen Abdeckung 5 und wannenartigem Teil 4 liegt (Fig. 4).

Aus Fig. 4 ist weiters zu sehen, dass die elektrischen Anschlussstellen 6 in einer Seitenwand 4a des wannenartigen Teils 4 angeordnet sind. Diese Seitenwand 4a schliesst mit dem Boden 4b des wannenartigen Teils 4 im Inneren der Kammer 3 einen stumpfen Winkel α ein. Der stumpfe Winkel α beträgt bevorzugt zwischen 100° und 150°, z. B. im Wesentlichen 120°.

Die Prüfvorrichtung 1 - gemäss der bevorzugten Ausführungsform - weist ein die Kammer 3 tragendes - vorzugsweise verfahrbares (siehe Rollen in Fig. 1 und 5) - Gestell 13 auf. Die Kammer 3 und das Gestell 13 können dabei einen Tisch bilden. Zumindest der wannenartige Teil 4 der Kammer 3 kann als ein vom Gestell 13 abnehmbarer Einsatz ausgebildet sein (Fig. 4).

Das Gestell 13 kann zumindest eine mit der zumindest einen elektrischen Anschlussstelle 6 verbundene Spannungsquelle 8 und/oder eine mit der Kammer 3 verbundene Vakuumpumpe 10 und/oder eine Steuereinrichtung 11 zur Steuerung der Prüfvorrichtung 1 und/oder eine Benutzerschnittstelle 12 (z. B. einen Bildschirm und/oder eine Tastatur und/oder einen Touchscreen) zur Bedienung der Prüfvorrichtung 1 tragen.

Aus Fig. 1 ist zu sehen, dass die Kammer 3 - hier: in ihrer Abdeckung 5 - zumindest ein Sichtfenster 15 oder zumindest einen durchsichtigen Abschnitt aufweisen kann.

Die Abdeckung 5 der Kammer 3 wird durch eine vorzugsweise horizontal verschiebbare Platte, welche eine Tischplatte der Prüfvorrichtung 1 bildet, gebildet. Die Abdeckung 5 kann somit zwischen geschlossener und geöffneter Stellung, vorzugsweise in einer horizontalen Richtung, verschiebbar sein. In der Ausführungsform der Fig. 1 ist die Abdeckung durch eine, bevorzugt rollengelagerte, Führung 18 geführt. Diese Führung 18 ist in Fig. 1 jeweils im Randbereich des Tisches angeordnet.

Fig. 3 zeigt eine mögliche Anschlusssituation zwischen einer Anschlussstelle 6 (hier einer Anschlussbuchse) und einem Steckvorrichtungsteil 20 einer zu prüfenden Leitung 2. Es ist zu sehen, dass in einem Bereich zwischen der elektrischen Anschlussstelle 6 und einer Wand der Kammer 3 eine Dichtung 16 zur Abdichtung des Inneren der Kammer 3 gegenüber dem Bereich ausserhalb der Kammer 3 angeordnet ist.

Zusätzlich weist die zumindest eine elektrische Anschlussstelle 6 eine dem Inneren der Kammer 3 bzw. - bei angeschlossener Leitung 2 - dem Steckvorrichtungsteil 20 zugewandte - Dichtung 17 auf, um bei angeschlossenem elektrischen Leiter 2 das Innere der Kammer 3 gegen einen zwischen der elektrischen Anschlussstelle 6 und dem Steckvorrichtungsteil 20 gebildeten Raum abzudichten.

Die zumindest eine elektrische Anschlussstelle 6 kann auch einen Fixiermechanismus, vorzugsweise einen Schnappmechanismus, zum Fixieren eines Steckvorrichtungsteils 20 der zu prüfenden elektrischen Leitung 2 an der Anschlussstelle 6 aufweisen.

Fig. 4 zeigt ein weiteres bevorzugtes Merkmal, nämlich einen auf dem Boden 4b der Kammer angeordneten Abstandhalter 19 aus elektrisch isolierendem Material, vorzugsweise in Form eines Gitters oder Netzes oder in Form von Leisten, zur Beabstandung einer zu prüfenden elektrischen Leitung 2 vom Boden 4b der Kammer 3, welcher Boden 4b hier auch die (Gegen-)Elektrode bildet.

Fig. 6 zeigt eine weitere Ausführungsform der Erfindung mit Sensorvorrichtungen 21 zur Detektion und/oder Lokalisierung eines Durchschlages durch die Isolierung der zu prüfenden elektrischen Leitung 2 und/oder zur Überwachung bzw. Kontrolle der angelegten elektrischen (Prüf-)Spannung. Als Sensorvorrichtung kann eine elektrische Messeinrichtung 22 (z. B. ein Amperemeter und/oder Voltmeter) ausserhalb der Kammer 3 und/oder eine optische Erfassungsvorrichtung 23 (z. B. eine Kamera) im Inneren der Kammer 3 vorgesehen sein.

Wie aus Fig. 6 zu sehen, kann es im Inneren der Kammer 3 zumindest zwei elektrische Anschlussstellen 6 geben, wobei eine der Anschlussstellen 6 mit einer (ausserhalb der Kammer 3 angeordneten) Spannungsquelle 8 und eine andere Anschlussstelle 6 mit der (ausserhalb der Kammer 3 angeordneten) Messeinrichtung 22 verbunden ist. Eine zu prüfende elektrische Leitung 2 wird mit einem ihrer Enden über die eine Anschlussstelle 6 an die Spannungsquelle 8 und mit einem anderen Ende über die andere Anschlussstelle an die Messeinrichtung 22 angeschlossen. Selbstverständlich können die Messeinrichtung 22, die Spannungsquelle 8 und gegebenenfalls auch die Steuereinrichtung 11 in einer gemeinsamen baulichen Einheit integriert sein.

Die Elektrode 24 ist in Fig. 6 gesondert dargestellt. Wie bereits mehrfach erwähnt, kann auch das Gehäuse der Kammer 3 selbst die Gegenelektrode bilden.

Die Sensoreinrichtungen 21 sind - ebenso wie die Spannungsquelle 8 - mit der Steuereinrichtung 11 verbunden und werden durch diese angesteuert.

Schliesslich bezieht sich die Erfindung auch auf ein Prüfverfahren zur Prüfung der Isolierung einer elektrischen Leitung 2, insbesondere eines Kabels oder eines Kabelbaumes, vorzugsweise zur Detektion von Fehlstellen in der Isolierung der elektrischen Leitung 2, mittels einer erfindungsgemässen Prüfvorrichtung. Das Verfahren umfasst die Schritte:
- Einbringen zumindest einer zu prüfenden elektrischen Leitung 2 in die Kammer 3 und Anschliessen der elektrischen Leitung 2 an zumindest eine elektrische Anschlussstelle 6 der Kammer 3,
- Evakuieren der Kammer 3 mittels einer Vakuumpumpe 10, vorzugsweise bis ein Druck von weniger als 500mbar, vorzugsweise weniger als 200mbar, besonders bevorzugt weniger als 100mbar, in der Kammer 3 erreicht ist,
- Anlegen einer elektrischen Spannung zwischen der zu prüfenden elektrischen Leitung 2 und einer Innenseite der Kammer 3 und/oder zwischen zu prüfenden elektrischen Leitungen 2.

Während die elektrische Spannung angelegt ist, wird mittels der Sensoreinrichtung 21, welche - direkt oder indirekt - mit der zu prüfenden Leitung 2 und/oder der Elektrode 24 verbunden ist, überwacht, ob ein Durchschlag erfolgt bzw. inwieweit die elektrische Spannung abfällt. Die Sensoreinrichtung 21 kann z. B. ein Amperemeter, ein Voltmeter, ein elektrisches Feldmeter und/oder eine optische Erfassungseinrichtung (wie z. B. eine Kamera) zur Erfassung eines aus der Isolierung austretenden Lichtbogens umfassen.

Eine bevorzugte Ausführungsform zeichnet sich dadurch aus, dass der Schritt des Anlegens der elektrischen Spannung und der Schritt der Überwachung der elektrischen Leitung 2 bei evakuierter Kammer 3 (d. h. wenn in der Kammer 3 Unterdruck bzw. Vakuum herrscht) durchgeführt werden, vorzugsweise bei einem Druck in der Kammer 3 von weniger als 500mbar, vorzugsweise weniger als 200mbar, besonders bevorzugt weniger als 100mbar.

Die Erfindung wird durch die beigefügten Ansprüche definiert.

### Bezugszeichenliste

- 1: Prüfvorrichtung
- 2: zu prüfende elektrische Leitung
- 3: Kammer
- 4: wannenartiger Teil
- 4a: Seitenwand des wannenartigen Teils 4
- 4b: Boden des wannenartigen Teils 4
- 5: Abdeckung
- 6: elektrische Anschlussstelle
- 7: elektrische Durchführung
- 8: Spannungsquelle
- 9: Trägerelement
- 10: Vakuumpumpe
- 11: Steuereinrichtung
- 12: Benutzerschnittstelle
- 13: Gestell
- 14: Dichtung
- 15: Sichtfenster
- 16: Dichtung
- 17: Dichtung
- 18: Führung
- 19: Abstandhalter
- 20: Steckvorrichtungsteil der elektrischen Leitung 2
- 21: Sensorvorrichtung
- 22: elektrische Messeinrichtung
- 23: optische Erfassungseinrichtung
- 24: Elektrode

## Patentansprüche

1. Prüfvorrichtung (1) zur Prüfung der Isolierung einer elektrischen Leitung (2), insbesondere eines Kabels oder eines Kabelbaumes, vorzugsweise zur Detektion von Fehlstellen in der Isolierung der elektrischen Leitung (2), **dadurch gekennzeichnet, dass** die Prüfvorrichtung (1) eine Kammer (3) zur vollständigen Aufnahme der zu prüfenden elektrischen Leitung (2) aufweist, wobei die Kammer (3) dicht verschliessbar und evakuierbar ist, sodass ein Vakuum, zumindest aber ein Unterdruck, im Inneren der Kammer (3) erzeugt werden kann, und wobei im Inneren der Kammer (3) zumindest eine elektrische Anschlussstelle (6), vorzugsweise in Form eines Steckvorrichtungsteils, zum Anschliessen der zu prüfenden elektrischen Leitung (2) angeordnet ist und von der Anschlussstelle (6) eine elektrische Durchführung (7) aus der Kammer (3) herausführt.

2. Prüfvorrichtung nach Anspruch 1, **dadurch gekennzeichnet, dass** zumindest ein Teil, vorzugsweise zumindest die Hälfte oder zumindest der Boden, des Gehäuses der Kammer (3) aus leitfähigem Material, insbesondere Metall, gebildet ist, welches mit einer Spannungsquelle (8) und/oder einem Potential, vorzugsweise Erde, verbunden ist.

3. Prüfvorrichtung nach Anspruch 1 oder 2, **dadurch gekennzeichnet, dass** im Inneren der Kammer (3) zumindest zwei, vorzugsweise zumindest fünf elektrische Anschlussstellen (6), vorzugsweise jeweils in Form eines Steckvorrichtungsteils, angeordnet sind, wobei vorzugsweise von den Anschlussstellen (6) jeweils eine elektrische Durchführung (7) aus der Kammer (3) herausführt oder wobei vorzugsweise die Anschlussstellen (6) unterschiedliche Form aufweisen,
**und/oder dass** zumindest zwei, vorzugsweise zumindest fünf elektrische Anschlussstellen (6), vorzugsweise jeweils in Form eines Steckvorrichtungsteils, an einem gemeinsamen Trägerelement (9), vorzugsweise in Form einer Leiste oder Platte, welches vom Gehäuse der Kammer (3) abnehmbar ist, verankert sind.

4. Prüfvorrichtung nach einem der vorhergehenden Ansprüche, **dadurch gekennzeichnet, dass** die zumindest eine elektrische Anschlussstelle (6) in oder an einer Innenwand der Kammer (3) verankert ist.

5. Prüfvorrichtung nach einem der vorhergehenden Ansprüche, **dadurch gekennzeichnet, dass** die zumindest eine elektrische Anschlussstelle (6) über die elektrische Durchführung (7) mit einer ausserhalb der Kammer (3) angeordneten Spannungsquelle (8) verbunden ist
**und/oder dass** die Prüfvorrichtung (1) eine mit der Kammer (3) verbundene Vakuumpumpe (10) zum Evakuieren der Kammer (3) aufweist.

6. Prüfvorrichtung einem der vorhergehenden Ansprüche, **dadurch gekennzeichnet, dass** die Kammer (3) durch einen wannenartigen Teil (4) und eine den wannenartigen Teil (4) abdeckende Abdeckung (5) gebildet wird, wobei vorzugsweise zwischen wannenartigem Teil (4) und Abdeckung (5) eine Dichtung (14) vorgesehen ist, die im geschlossenen Zustand der Kammer zwischen Abdeckung (5) und wannenartigem Teil (4) liegt.

7. Prüfvorrichtung nach Anspruch 6, **dadurch gekennzeichnet, dass** die zumindest eine elektrische Anschlussstelle (6) in einer Seitenwand (4a) des wannenartigen Teils (4) angeordnet ist, wobei die Seitenwand (4a) mit dem Boden (4b) des wannenartigen Teils (4) im Inneren der Kammer (3) einen stumpfen Winkel (α) einschliesst, wobei vorzugsweise der stumpfe Winkel (α) zwischen 100° und 150°, vorzugsweise im Wesentlichen 120°, beträgt.

8. Prüfvorrichtung nach einem der vorhergehenden Ansprüche, **dadurch gekennzeichnet, dass** die Prüfvorrichtung (1) ein die Kammer (3) tragendes, vorzugsweise verfahrbares Gestell (13) aufweist, wobei vorzugsweise die Kammer (3) und das Gestell (13) einen Tisch bilden.

9. Prüfvorrichtung nach Anspruch 8, **dadurch gekennzeichnet, dass** zumindest der wannenartige Teil (4) der Kammer (3) einen vom Gestell (13) abnehmbaren Einsatz bildet.

10. Prüfvorrichtung nach Anspruch 8 oder 9, **dadurch gekennzeichnet, dass** das Gestell (13) zumindest eine mit der zumindest einen elektrischen Anschlussstelle (6) verbundene Spannungsquelle (8) und/oder eine mit der Kammer (3) verbundene Vakuumpumpe (10) und/oder eine Steuereinrichtung (11) zur Steuerung der Prüfvorrichtung (1) und/oder eine Benutzerschnittstelle (12) zur Bedienung der Prüfvorrichtung (1) trägt.

11. Prüfvorrichtung nach einem der vorhergehenden Ansprüche, **dadurch gekennzeichnet, dass** die Kammer (3), vorzugsweise in ihrer Abdeckung (5), zumindest ein Sichtfenster (15) oder zumindest einen durchsichtigen Abschnitt aufweist
**und/oder dass** die Abdeckung (5) durch eine vorzugsweise horizontal verschiebbare Platte, welche eine Tischplatte der Prüfvorrichtung (1) bildet, gebildet wird
**und/oder dass** die Abdeckung (5) zwischen geschlossener und geöffneter Stellung, vorzugsweise in einer horizontalen Richtung, verschiebbar ist, wobei vorzugsweise die Abdeckung durch eine, bevorzugt rollengelagerte, Führung (18) geführt ist.

12. Prüfvorrichtung nach einem der vorhergehenden Ansprüche, **dadurch gekennzeichnet, dass** in einem Bereich zwischen der elektrischen Anschlussstelle (6) und einer Wand der Kammer (3) eine Dichtung (16) zur Abdichtung des Inneren der Kammer (3) gegenüber dem Bereich ausserhalb der Kammer (3) angeordnet ist
**und/oder dass** die zumindest eine elektrische Anschlussstelle (6) eine - vorzugsweise dem Inneren der Kammer (3) zugewandte - Dichtung (17) aufweist, um bei angeschlossenem elektrischen Leiter (2) das Innere der Kammer (3) gegen einen zwischen der elektrischen Anschlussstelle (6) und einem Steckvorrichtungsteil (20) der zu prüfenden elektrischen Leitung (2) gebildeten Raum abzudichten.

13. Prüfvorrichtung nach einem der vorhergehenden Ansprüche, **dadurch gekennzeichnet, dass** die Prüfvorrichtung (1) zumindest eine Sensorvorrichtung (21) zur Detektion und/oder Lokalisierung eines Durchschlages durch die Isolierung der zu prüfenden elektrischen Leitung (2) und/oder zur Überwachung einer an die elektrische Leitung (2) angelegten elektrischen Spannung aufweist, wobei vorzugsweise die Sensorvorrichtung (21) eine, vorzugsweise ausserhalb der Kammer (3) angeordnete, mit einer elektrischen Anschlussstelle (6) verbundene elektrische Messeinrichtung (22) oder eine, vorzugsweise im Inneren der Kammer (3) angeordnete, optische Erfassungseinrichtung (23) ist.

14. Prüfvorrichtung nach einem der vorhergehenden Ansprüche, **dadurch gekennzeichnet, dass** die zumindest eine elektrische Anschlussstelle (6) einen Fixiermechanismus, vorzugsweise einen Schnappmechanismus, zum Fixieren eines Steckvorrichtungsteils (20) der zu prüfenden elektrischen Leitung (2) an der Anschlussstelle (6) aufweist,
**und/oder dass** auf dem Boden (4b) der Kammer ein Abstandhalter (19) aus elektrisch isolierendem Material, vorzugsweise in Form eines Gitters oder Netzes oder in Form von Leisten, zur Beabstandung einer zu prüfenden elektrischen Leitung (2) vom Boden (4b) der Kammer (3) angeordnet ist.

15. Prüfverfahren zur Prüfung der Isolierung einer elektrischen Leitung (2), insbesondere eines Kabels oder eines Kabelbaumes, vorzugsweise zur Detektion von Fehlstellen in der Isolierung der elektrischen Leitung (2), mittels einer Prüfvorrichtung (1), **dadurch gekennzeichnet, dass** die Prüfvorrichtung (1) eine Prüfvorrichtung nach einem der vorhergehenden Ansprüche ist und das Verfahren die Schritte umfasst:
- Einbringen zumindest einer zu prüfenden elektrischen Leitung (2) in die Kammer (3) und Anschliessen der elektrischen Leitung (2) an zumindest eine elektrische Anschlussstelle (6) der Kammer (3),
- Evakuieren der Kammer (3), vorzugsweise bis ein Druck von weniger als 500mbar, vorzugsweise weniger als 200mbar, besonders bevorzugt weniger als 100mbar, in der Kammer (3) erreicht ist,
- Anlegen einer elektrischen Spannung zwischen der zu prüfenden elektrischen Leitung (2) und einer Elektrode (24), welche vorzugsweise zumindest eine Innenseite der Kammer (3) bildet oder innerhalb der Kammer (3) angeordnet ist, und/oder zwischen zu prüfenden elektrischen Leitungen (2).

## Claims

1. A test device (1) for testing the insulation of an electrical line (2), particularly a cable or a cable harness, preferably for detecting flaws in the insulation of the electrical line (2), **characterized in that** the test device (1) has a chamber (3) for completely accommodating the electrical line (2) to be tested, wherein the chamber (3) can be closed and evacuated in a sealed manner, so a vacuum, but at least an underpressure, can be generated in the interior of the chamber (3), and wherein at least one electrical connection point (6), preferably in the form of a connector part, is arranged in the interior of the chamber (3) for connecting the electrical line (2) to be tested, and an electrical bushing (7) leads out of the chamber (3) from the connection point (6).

2. The test device according to Claim 1, **characterized in that** at least a part, preferably at least half or at least the base, of the housing of the chamber (3) is formed from conductive material, particularly metal, which is connected to a voltage source (8) and/or a potential, preferably earth.

3. The test device according to Claim 1 or 2, **characterized in that** at least two, preferably at least five electrical connection points (6) are arranged, preferably in the form of a connector part in each case, in the interior of the chamber (3), wherein one electrical bushing (7) in each case preferably leads out of the chamber (3) from the connection points (6) or wherein the connection points (6) preferably have a different form,
and/or **in that** at least two, preferably at least five electrical connection points (6), preferably in the form of a connector part in each case, are anchored to a common support element (9), preferably in the form of a strip or plate, which can be removed from the housing of the chamber (3).

4. The test device according to one of the preceding claims, **characterized in that** the at least one electrical connection point (6) is anchored in or to an inner wall of the chamber (3).

5. The test device according to one of the preceding claims, **characterized in that** the at least one electrical connection point (6) is connected via the electrical bushing (7) to a voltage source (8) arranged outside the chamber (3)
and/or **in that** the test device (1) has a vacuum pump (10), which is connected to the chamber (3), for evacuating the chamber (3).

6. The test device according to one of the preceding claims, **characterized in that** the chamber (3) is formed by a trough-like part (4) and a cover (5) which covers the trough-like part (4), wherein a seal (14) is preferably provided between trough-like part (4) and cover (5), which seal lies between cover (5) and trough-like part (4) in the closed state of the chamber.

7. The test device according to Claim 6, **characterized in that** the at least one electrical connection point (6) is arranged in a side wall (4a) of the trough-like part (4), wherein the side wall (4a) encloses an obtuse angle (α) with the base (4b) of the trough-like part (4) in the interior of the chamber (3), wherein the obtuse angle (α) is preferably between 100° and 150°, preferably essentially 120°.

8. The test device according to one of the preceding claims, **characterized in that** the test device (1) has a frame (13), which carries the chamber (3) and is preferably movable, wherein the chamber (3) and the frame (13) preferably form a table.

9. The test device according to Claim 8, **characterized in that** at least the trough-like part (4) of the chamber (3) forms an insert which can be removed from the frame (13) .

10. The test device according to Claim 8 or 9, **characterized in that** the frame (13) carries at least one voltage source (8), which is connected to the at least one electrical connection point (6), and/or a vacuum pump (10), which is connected to the chamber (3), and/or a control device (11) for controlling the test device (1) and/or a user interface (12) for operating the test device (1).

11. The test device according to one of the preceding claims, **characterized in that** the chamber (3) has at least one inspection window (15) or at least one transparent section preferably in the cover (5) of the chamber
and/or **in that** the cover (5) is formed by a preferably horizontally displaceable plate, which forms a tabletop of the test device (1)
and/or **in that** the cover (5) is displaceable, preferably in a horizontal direction, between a closed and an open position, wherein the cover is preferably guided by a guide (18), which is preferably mounted on roller bearings.

12. The test device according to one of the preceding claims, **characterized in that** a seal (16) for sealing the interior of the chamber (3) with respect to the region outside the chamber (3) is arranged in a region between the electrical connection point (6) and a wall of the chamber (3)
and/or **in that** the at least one electrical connection point (6) has a seal (17) - preferably facing the interior of the chamber (3) - in order, when the electrical conductor (2) is connected, to seal the interior of the chamber (3) with respect to a space formed between the electrical connection point (6) and a connector part (20) of the electrical line (2) to be tested.

13. The test device according to one of the preceding claims, **characterized in that** the test device (1) has at least one sensor device (21) for detecting and/or localizing an electrical breakdown through the insulation of the electrical line (2) to be tested and/or for monitoring an electric voltage applied to the electrical line (2), wherein the sensor device (21) is preferably an electric measuring device (22), which is preferably arranged outside the chamber (3) and is connected to an electrical connection point (6), or an optical recording device (23), which is preferably arranged in the interior of the chamber (3).

14. The test device according to one of the preceding claims, **characterized in that** the at least one electrical connection point (6) has a fixing mechanism, preferably a snap mechanism, for fixing a connector part (20) of the electrical line (2) to be tested to the connection point (6),
and/or **in that** a spacer (19) made from electrically insulating material, preferably in the form of a mesh or net or in the form of strips, is arranged on the base (4b) of the chamber for spacing an electrical line (2) to be tested from the base (4b) of the chamber (3).

15. A testing method for testing the insulation of an electrical line (2), particularly a cable or a cable harness, preferably for detecting flaws in the insulation of the electrical line (2), by means of a test device (1), **characterized in that** the test device (1) is a test device according to one of the preceding claims and the method comprises the steps:
- introducing at least one electrical line (2) to be tested into the chamber (3) and connecting the electrical line (2) to at least one electrical connection point (6) of the chamber (3),
- evacuating the chamber (3), preferably until a pressure of less than 500 mbar, preferably less than 200 mbar, particularly preferably less than 100 mbar, is reached in the chamber (3),
- applying an electric voltage between the electrical line (2) to be tested and an electrode (24), which preferably forms at least one inner side of the chamber (3) or is arranged inside the chamber (3), and/or between electrical lines (2) to be tested.

## Revendications

1. Dispositif de test (1), destiné à tester l'isolation d'une conduite (2) électrique, notamment d'un câble ou d'un faisceau de câbles, de préférence à détecter des défauts dans l'isolation de la conduite (2) électrique, **caractérisé en ce que** le dispositif de test (1) comporte un compartiment (3) pour réceptionner en totalité la conduite (2) électrique qui doit être testée, le compartiment (3) étant susceptible d'être fermé de manière étanche et évacué, de telle sorte qu'un vide, mais pour le moins une dépression puisse être généré(e) à l'intérieur du compartiment (3) et à l'intérieur du compartiment (3) étant placé au moins un point de connexion (6) électrique, de préférence sous la forme d'une pièce de connecteur, pour la connexion de la conduite (2) qui doit être testée et à partir du point de connexion (6), un passage (7) électrique menant hors du compartiment (3).

2. Dispositif de test selon la revendication 1, **caractérisé en ce qu'**au moins une partie, de préférence au moins la moitié ou au moins le fond inférieur du boîtier du compartiment (3) est constitué(e) en une matière conductrice, notamment en métal, lequel est relié avec une source de tension (8) et / ou un potentiel, de préférence la terre.

3. Dispositif de test selon la revendication 1 ou 2, **caractérisé en ce qu'**à l'intérieur du compartiment (3) sont placés au moins deux, de préférence au moins cinq points de connexion (6) électrique, de préférence chacun sous la forme d'une pièce de connecteur, de préférence à partir des points de connexion (6), chaque fois un passage (7) électrique menant hors du compartiment (3) ou de préférence les points de connexion (6) présentant une forme différente,
et / ou **en ce qu'**au moins deux, de préférence au moins cinq points de connexion (6) électrique, de préférence chacun sous la forme d'une pièce de connecteur sont ancrés sur un élément de support (9) commun, de préférence sous la forme d'une baguette ou d'une plaque, qui est amovible du boîtier du compartiment (3) .

4. Dispositif de test selon l'une quelconque des revendications précédentes, **caractérisé en ce que** l'au moins un point de connexion (6) électrique est ancré dans ou sur une paroi intérieure du compartiment (3).

5. Dispositif de test selon l'une quelconque des revendications précédentes, **caractérisé en ce que** l'au moins un point de connexion (6) électrique est relié par l'intermédiaire du passage (7) électrique avec une source de tension (8) placée à l'extérieur du compartiment (3)
et / ou **en ce que** le dispositif de test (1) comporte une pompe à vide (10) reliée avec le compartiment (3), pour évacuer le compartiment (3).

6. Dispositif de test selon l'une quelconque des revendications précédentes, **caractérisé en ce que** le compartiment (3) est constitué d'une pièce (4) en forme de cuve et d'un couvercle (5) recouvrant la pièce (4) en forme de cuve, de préférence entre la pièce (4) en forme de cuve et le couvercle (5) étant prévu un joint (14) qui lorsque le compartiment est fermé, se situe entre le couvercle (5) et la pièce (4) en forme de cuve.

7. Dispositif de test selon la revendication 6, **caractérisé en ce que** l'au moins un point de connexion (6) électrique est placé dans une paroi latérale (4a) de la pièce (4) en forme de cuve, la paroi latérale (4a) incluant avec le fond inférieur (4b) de la pièce (4) en forme de cuve à l'intérieur du compartiment (3) un angle obtus (α), de préférence l'angle obtus (α) étant compris entre 100 ° et 150 °, de préférence étant de sensiblement 120 °.

8. Dispositif de test selon l'une quelconque des revendications précédentes, **caractérisé en ce que** le dispositif de test (1) comporte un châssis (13) portant le compartiment (3), de préférence déplaçable, de préférence le compartiment (3) et le châssis (13) constituant une table.

9. Dispositif de test selon la revendication 8, **caractérisé en ce qu'**au moins la pièce (4) en forme de cuve du compartiment (3) constitue un insert amovible du châssis (13).

10. Dispositif de test selon la revendication 8 ou 9, **caractérisé en ce que** le châssis (13) porte au moins une source de tension (8) reliée avec l'au moins un point de connexion (6) électrique et / ou une pompe à vide (10) reliée avec le compartiment (3) et / ou un système de commande (11), destiné à commander le dispositif de test (1) et / ou un interface utilisateur (12), destinée à manipuler le dispositif de test (1).

11. Dispositif de test selon l'une quelconque des revendications précédentes, **caractérisé en ce que** le compartiment (3), comporte de préférence dans son couvercle (5), au moins un hublot (15) ou au moins une portion transparente
et / ou **en ce que** couvercle (5) est constitué d'une plaque de préférence déplaçable à l'horizontale, laquelle constitue un plateau de table du dispositif de test (1)
et / ou **en ce que** le couvercle (5) est déplaçable entre la position fermée et ouverte, de préférence dans une direction horizontale, de préférence le couvercle étant guidé par un guidage (18), logé de préférence sur des galets.

12. Dispositif de test selon l'une quelconque des revendications précédentes, **caractérisé en ce que** dans une zone entre le point de connexion (6) électrique et une paroi du compartiment (3) est placé un joint (16), destiné à assurer l'étanchéité de l'intérieur du compartiment (3) par rapport à la zone extérieure au compartiment (3)
et / ou **en ce que** l'au moins un point de connexion (6) électrique comporte un joint (17) (qui fait face de préférence à l'intérieur du compartiment (3), pour assurer l'étanchéité, lorsque le conducteur (2) électrique est connecté de l'intérieur du compartiment (3) par rapport à un espace constitué entre le point de connexion (6) électrique et une pièce de connecteur (20) de la conduite (2) électrique qui doit être testée.

13. Dispositif de test selon l'une quelconque des revendications précédentes, **caractérisé en ce que** le dispositif de test (1) comporte au moins un dispositif de capteur (21), destiné à détecter et / ou à localiser un claquage à travers l'isolation de la conduite (2) électrique qui doit être testée et / ou à contrôler une tension électrique appliquée sur la conduite (2) électrique, de préférence le dispositif de capteur (21) étant un système de mesure (22), placé de préférence à l'extérieur du compartiment (3), relié avec un point de connexion (6) électrique ou un système de détection (23) optique, placé de préférence à l'intérieur du compartiment (3).

14. Dispositif de test selon l'une quelconque des revendications précédentes, **caractérisé en ce que** l'au moins un point de connexion (6) électrique comporte un mécanisme de fixation, de préférence un mécanisme d'encliquetage, pour fixer une pièce de connecteur (20) de la conduite (2) qui doit être testée sur le point de connexion (6),
et / ou **en ce que** sur le fond inférieur (4b) du compartiment est placé un espaceur (19) en une matière isolante électrique, de préférence sous la forme d'un treillis ou d'un réseau ou sous la forme de baguettes, pour écarter une conduite (2) électrique qui doit être testée du fond inférieur (4b) du compartiment (3).

15. Procédé de test, destiné à tester l'isolation d'une conduite (2) électrique, notamment d'un câble ou d'un faisceau de câbles, de préférence à détecter des défauts dans l'isolation de la conduite (2) électrique au moyen d'un dispositif de test (1), **caractérisé en ce que** le dispositif de test (1) est un dispositif de test selon l'une quelconque des revendications précédentes et **en ce que** le procédé comprend les étapes consistant à :
- introduire au moins une conduite (2) qui doit être testée dans le compartiment (3) et connecter la conduite (2) électrique sur au moins un point de connexion (6) électrique du compartiment (3),
- évacuer le compartiment (3), de préférence jusqu'à ce qu'une pression inférieure à 500 mbar, de préférence inférieure à 200 mbar, de manière particulièrement préférentielle, inférieure à 100 mbar soit atteinte dans le compartiment (3),
- appliquer une tension électrique entre la conduite (2) électrique qui doit être testée et une électrode (24), laquelle constitue de préférence au moins une face intérieure du compartiment (3) ou est placée à l'intérieur du compartiment (3) et / ou entre des conduites (2) électriques qui doivent être testées.
